# EUROPEAN PATENT SPECIFICATION

(11) **EP 2 892 834 B1**
(45) Date of publication and mention of the grant of the patent: **02.05.2018**
(21) Application number: 12766015.7
(22) Date of filing: 10.09.2012
(51) Int. Cl.: B65G 49/06, C23C 14/50, C23C 14/56, H01L 21/67, H01L 21/677

(54) **SUBSTRATE TRANSFER DEVICE AND METHOD OF MOVING SUBSTRATES**
SUBSTRATÜBERTRAGUNGSVORRICHTUNG UND VERFAHREN ZUM BEWEGEN VON SUBSTRATEN
DISPOSITIF DE TRANSFERT DE SUBSTRAT ET PROCÉDÉ DE DÉPLACEMENT DE SUBSTRATS

(43) Date of publication of application: 15.07.2015
(73) Proprietor: Applied Materials, Inc., Santa Clara, CA 95054 (US)
(72) Inventor: LINDENBERG, Ralph, 63654 Büdingen (DE)
(74) Representative: Zimmermann & Partner Patentanwälte mbB
(86) International application number: PCT/EP2012/067659
(87) International publication number: WO 2014/037058

(56) References cited:
- WO-A1-2009/119580
- WO-A1-2009/156196
- US-A1- 2012 213 938

## Description

### FIELD OF THE INVENTION

Embodiments of the present invention relate to transfer devices for substrate transfer and to methods of moving substrates in a substrate processing system. Specifically, some embodiments relate to a transfer device for substrate transfer along a transport direction and for moving substrates perpendicularly thereto for aligning them alternatively with a first transport path and a second transport path extending along the transport direction. More specifically, some embodiments relate to a transfer device in a vacuum chamber of a substrate processing system for transferring substantially vertically oriented substrates.

### BACKGROUND OF THE INVENTION

In a number of technical applications, e.g., TFT metallization processes, layers of different materials are deposited onto each other over a substrate. Typically, this is done in a sequence of coating or deposition steps, e.g., sputtering steps, wherein other processing steps like etching or structuring might also be provided before, between, or after the various deposition steps. For example, a multi-layer stack with a sequence of "material one"-"material two"-"material one" can be deposited. Due to different coating rates in different process steps and due to different thicknesses of the layers, the processing time in the processing chambers for depositing different layers may vary considerably.

In order to deposit a multiple layer stack, a number of configurations of processing chambers can be provided. For example, in-line arrangements of deposition chambers can be used as well as cluster arrangements of deposition chambers. A typical cluster arrangement includes a central handling chamber and a number of processing or deposition chambers connected thereto. The coating chambers may be equipped to carry out the same or different processes. A typical in-line system includes a number of subsequent processing chambers, wherein processing steps are conducted in one chamber after the other such that a plurality of substrates can continuously or quasi-continuously be processed with the in-line system.

Cluster tools allow for different cycle times but the handling of substrates may be quite complex, requiring a complicated transfer system provided in the central handling chamber. The processing tact in in-line systems is typically determined by the longest processing time. Two transport paths may be provided so that a first substrate may overtake a second substrate that is being coated. If a change from one transport path to the other is required for a certain process conduct a handling device may be used to transfer the substrate, or a substrate carrier holding the substrate, from one path to the other, as described, e.g., in WO2009/156196 A1 or US 2012/0213938 A1. However, hooking up the substrate or carrier can cause undesired generation of particles due to the mechanical contact. The handling device also needs additional tact time, so process efficiency is lowered.

### SUMMARY

In light of the above, an apparatus and a method according to the independent claims are provided. Further details can be found in the dependent claims, the description, and the drawings.

According to one embodiment, a transfer device is provided for substrate transfer along a transport direction and for change between a first transport path and a second transport path extending along the transport direction. The first transport path is displaced with respect to the second transport path in a switch direction perpendicular to the transport direction. The transfer device includes a first substrate support assembly defining a first track to support a substrate or substrate carrier in a chamber. The transfer device further includes a second substrate support assembly defining a second track to support a substrate or substrate carrier in the chamber. The first substrate support assembly and the second substrate support assembly are moveable relative to each other at least in the switch direction.

The first substrate support assembly includes first support elements. The second substrate support assembly includes second support elements.

According to another embodiment, a chamber for a substrate processing system is provided. The chamber includes at least one first substrate transfer port for substrate transfer into or out of the chamber along a first transport path, and at least one second substrate transfer port for substrate transferring into or out of the chamber along a second transport path. The chamber further includes a transfer device arranged in the chamber, the transfer device being configured for substrate transfer along a transport direction and for change between a first transport path and a second transport path extending along the transport direction. The first transport path is displaced with respect to the second transport path in a switch direction perpendicular to the transport direction. The transfer device includes a first substrate support assembly defining a first track to support a substrate or substrate carrier in a chamber. The transfer device further includes a second substrate support assembly defining a second track to support a substrate or substrate carrier in the chamber. The first substrate support assembly and the second substrate support assembly are moveable relative to each other at least in the switch direction.

According to a further embodiment, a method of moving a substrate in a substrate processing system is provided. The method includes transferring the substrate into a chamber along a first transport path, and moving the substrate in the chamber at least in a switch direction perpendicular to the first transport path. The method further includes moving support elements of an empty substrate support assembly in the chamber. The substrate and the support elements of the empty substrate support assembly are moved relatively to each other in the switch direction and pass each other.

The disclosure is also directed to an apparatus for carrying out the disclosed methods, including apparatus parts for performing each of the described method steps. These method steps may be performed by way of hardware components, a computer programmed by appropriate software, by any combination of the two or in any other manner. Furthermore, the invention is also directed to methods by which the described apparatus operates or is manufactured. It includes method steps for carrying out every function of the apparatus.

### BRIEF DESCRIPTION OF THE DRAWINGS

So that the manner in which the above recited features can be understood in detail, a more particular description may be had by reference to embodiments. The accompanying drawings relate to embodiments and are described in the following:
- Figs. 1-2: show schematic illustrations of transfer devices for substrate transfer according to embodiments described herein;
- Figs. 3-4: show schematic illustrations of a chamber including a transfer device according to embodiments described herein;
- Figs. 5-8: illustrate embodiments of a transfer system described herein and illustrate embodiments of a method of moving a substrate described herein;
- Fig. 9: shows a transfer device in a chamber according to embodiments described herein;
- Figs. 10-13: show substrate support elements of a transfer device according to embodiments described herein;
- Figs. 14-19: show substrate support elements of a transfer device according to embodiments described herein; and
- Fig. 20: is a block diagram illustrating a method of moving a substrate according to embodiments described herein.

### DETAILED DESCRIPTION OF THE INVENTION

Reference will now be made in detail to the various exemplary embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same or similar components. Generally, only the differences with respect to the individual embodiments are described. The structures shown in the drawings are not necessarily depicted true to scale or angle, and may exaggerate features for a better understanding of the corresponding embodiments.

The term "direction" as used herein is not limited to the meaning of a vectored direction ("from A to B"), but includes both vectored directions in which a straight line can be followed ("from A to B" and "from B to A"). For example, the vertical direction shall include both the notions of up and down. Directions are therefore indicated by arrows with two arrow heads in the drawings.

The term "substrate" as used herein shall embrace substrates, such as glass substrates. Thereby, the substrates are typically large area substrates with a size of 1.4 m² and above, typically 5 m² and above. For example, substrate sizes of 1.43 m² (Gen5) and above, such as 5.5 m² (Gen8.5), 9 m² (Gen10) or larger can be realized.

Typically, the substrates are vertically oriented or substantially vertically oriented. Thereby, it is to be understood that a substantially vertically oriented substrate can have some deviation from a vertical orientation in a processing system in order to allow for stable transport with an inclination by a few degrees, e.g., at most 15° or at most 10°, e.g., from 5° to 7° or less. The substrates are then said to be substantially or essentially vertically oriented. A substrate is substantially vertically oriented if the normal to its largest surfaces (front and back surfaces) is substantially horizontally oriented, i.e., the normal has a tilt of at most a few degrees, e.g., at most 15° or at most 10°, e.g., from 5° to 7° or less. At least one of the largest surfaces, i.e., at least one of the front and back surfaces, is typically coated in substrate processing systems in which a substrate transfer device according to embodiments described herein may be used. A substantially horizontally oriented substrate has a normal to its largest surfaces that is tilted at most a few degrees from the vertical direction, such as at most 15° or at most 10°, such as from 5° to 7° or less.

According to an embodiment, a transfer device is provided. The transfer device is configured for substrate transfer. It may be called a substrate transfer device. The transfer device may be configured for transferring substantially vertically oriented substrates. The transfer device may alternatively be configured for transferring substantially horizontally oriented substrates, e.g., for sputter up or sputter down processing.

The substrates may be large-area substrates, e.g., glass substrates of Gen5 and higher, or even Gen8 and higher. Substrate transfer with substantially vertical orientation is particularly advantageous for large-area substrates. The problem of particle generation due to handling systems is more pronounced for vertically oriented substrates since particles generated at the top of the substrate due to handling may fall onto the substrate. A transfer device according to embodiments described herein is therefore particularly advantageous for transfer of substantially vertically oriented substrates.

The transfer device may be adapted to be arranged in a chamber of a substrate processing system, e.g., in a processing chamber, a transfer chamber, a lock chamber, or a swing module. Typically, the chambers are vacuum chambers. The substrate processing system may be an in-line substrate processing system or may at least partly be an in-line substrate processing system. The substrate processing system may be a system including vacuum deposition chambers for depositing layers onto substrates, e.g., sputter chambers. The substrate processing system may be a system for TFT metallization processes. In-line processing systems typically provide a sequence of chambers for depositing a sequence of layers. Thereby, one layer after the other is deposited in one chamber after the other. For example, a thin layer of molybdenum can be deposited over a substrate, subsequently a thick layer of aluminum is deposited over the molybdenum layer and a further thin layer of molybdenum is deposited over the aluminum layer.

The transfer device is configured for substrate transfer along a transport direction. The transfer device is further configured for change between a first transport path and a second transport path. In a change between the first and second transport path, a substrate or substrate carrier is moved from the first to the second transport path or vice versa. The first transport path and the second transport path extend along the transport direction. The first transport path and the second transport path are displaced with respect to each other in a switch direction. The switch direction is perpendicular to the transport direction.

The transfer device includes a first substrate support assembly and a second substrate support assembly. The first substrate support assembly defines a first track to support a substrate or substrate carrier in a chamber. The second substrate support assembly defines a second track to support a substrate or substrate carrier in the same chamber. A track is the space defined by a substrate support assembly that can support a substrate or substrate carrier.

Sometimes, a substrate or substrate carrier with vertical orientation is said to stand on or be placed on a track even though the substrate or substrate carrier may not only be supported from below, but may also be supported, e.g., held and/or guided, from above at the same time. A single substrate support assembly shall not be construed as an object simultaneously supporting several substrates or substrate carriers on different transport paths or as an object arranged in several chambers. One substrate support assembly might support more than one substrate or substrate carrier if more than one substrate or substrate carrier should fit in the track defined by the substrate support assembly, but typically supports only one substrate or substrate carrier.

The first substrate support assembly and the second substrate support assembly are moveable relative to each other at least in the switch direction. A relative movement of the first and second substrate support assemblies relative to each other in the switch direction includes the cases that only the first substrate support assembly is moved in the switch direction, that only the second substrate support assembly is moved in the switch direction, that both substrate support assemblies are moved in the switch direction opposite to each other, or that both substrate support assemblies are moved in the switch direction in the same vectored direction, but at different speeds.

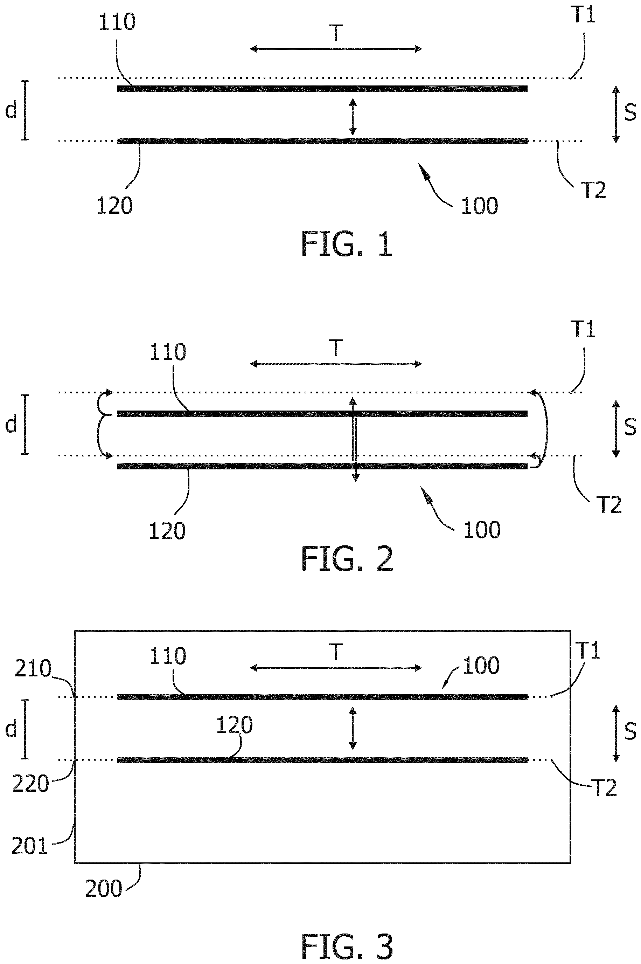

Fig. 1 shows a schematic illustration of a transfer device 100 according to an embodiment. The transfer device 100 is adapted to transfer substrates or substrate carriers along a first transport path T1 and along a second transport path T2 in a transport direction T. The transport paths T1 and T2 are separated by a distance d from each other in a switch direction S that is perpendicular to the transport direction T. The transfer device 100 includes a first substrate support assembly 110 and a second substrate support assembly 120. These substrate support assemblies are moveable relatively to each other in the switch direction S as indicated by the double-headed arrow between them.

In particular, when a substrate or substrate carrier is being supported by a track defined by one of the first and second substrate support assemblies, the substrate or substrate carrier can be moved together with said substrate support assembly in the switch direction. This situation may be called a substrate movement on or in the track that is supporting the substrate or substrate carrier. Sometimes it is called movement of a non-empty track or movement of a carrier supporting track or movement of substrate supporting track. The substrate or substrate carrier, when moved in the switch direction with the substrate support assembly, does not leave the track that is currently supporting it. No separate substrate handling device is needed that hooks up the substrate or substrate carrier and moves it from one track to the other. The risk of producing particles that may disturb subsequent substrate processing is greatly reduced. Further, there is an improvement in the tact time since no extra tact time required by a substrate handling device is needed.

Further, in particular when the transfer device is arranged in a substrate processing chamber, the capability of relative movement of the substrate support assemblies in the switch direction allows to save space in the processing region where deposition of layers onto the substrate takes place, e.g., as compared to the transferring means of WO 2009/156196 A1 with a rigidly connected, space consuming combination of three tracks. The capability of relative movement also increases the flexibility with respect to process conduct, therefore possibly allowing improved conduct of substrate processing with reduced tact times.

Fig. 1 can represent both a transfer device for transferring vertically oriented substrates and a transfer device for transferring horizontally oriented substrates. For vertically oriented substrates, Fig. 1 would show a top view. The vertical direction would be into and out of the plane of drawing, the transport paths along the transport direction would be in a first horizontal direction, and the switch direction S would be in a second horizontal direction perpendicular to the first horizontal direction. For horizontally oriented substrates, Fig. 1 would show a side view. The switch direction would be the vertical direction, and the transport direction would a horizontal direction.

According to some embodiments, the first substrate support assembly may be moveable in the switch direction. The second substrate support assembly may be moveable in the switch direction. The first and second substrate support assemblies may be moveable in the switch direction independently of each other. The first substrate support assembly may be moveable in the switch direction so that the first track, defined by the first substrate support assembly, can be aligned with the first transport path, and can be aligned also with the second transport path at a different time. In other words, the first track is alignable with the first transport path and alternatively with the second transport path. The second substrate support assembly may be moveable in the switch direction so that the second track, defined by the second substrate support assembly, can be aligned with the first transport path, and can be aligned also with the second transport path at a different time. In other words, the second track is alignable with the first transport path and alternatively with the second transport path.

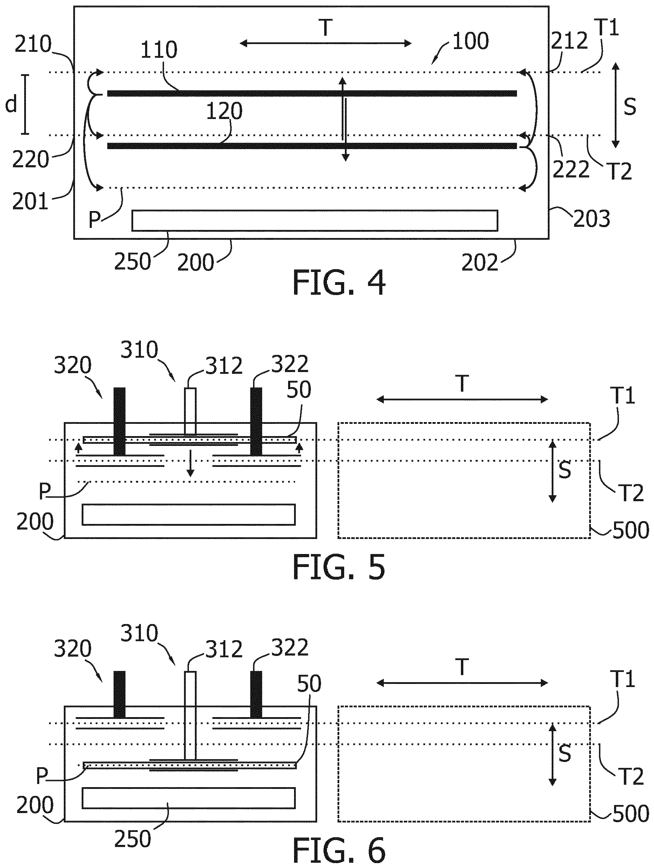

The first substrate support assembly and the second substrate support assembly may be moveable relative to each other such that the first track and the second track pass each other in the switch direction. Passing each other means the following. Let X be a plane having a normal that is parallel to the normal of the first and second tracks, where the plane X is not lying between the substrate support assemblies and therefore not between the tracks when viewed in the switch direction. If, at one point in time, the first substrate support assembly (and therefore the first track) is closer to the plane X measured in the switch direction than the second substrate support assembly (and therefore the second track), then the proximity relation is inverted after the first and second substrate support assemblies and therefore the first and second tracks have passed each other. After passing, the second substrate support assembly (and therefore the second track) is closer to the plane X measured in the switch direction than the first substrate support assembly (and therefore the first track). For illustration consider the plane containing the chamber wall 202 of chamber 200 in Fig. 4. The second substrate support assembly 120 and the second track are closer to the wall 202 in the switch direction S than the first substrate support assembly 110 and the first track. When the substrate support assemblies 110, 120 and therefore the first and second tracks pass each other, the first substrate support assembly 110 and the first track will be closer to the chamber wall 202 than the second substrate support assembly 120 and the second track.

Passing may also be referred to as switching. The direction of relative movement is therefore called switching direction herein. Switching does not necessarily imply that the first track occupies the former position of the second track and vice versa. The first and second substrate support assemblies may exchange their mutual positions, so that the corresponding tracks are exchanged, but this need not necessarily be the case.

Fig. 2 illustrates alignment and passing. Substrate support assembly 110 has the option to be aligned with the first transport path T1, and has the option to be aligned with the second transport path T2 as indicated by the curved arrows to the left of substrate support assembly 110. The second substrate support assembly 120 also has the option to be aligned with the first transport path T1, and has the option to be aligned with the second transport path T2 as indicated by the curved arrows to the right of the second substrate support assembly 120. The first substrate support assembly 110 can pass the second substrate support assembly 120, and vice versa, as indicated by the two opposing arrows in the middle of the figure.

According to further embodiments, a chamber for a substrate processing system is provided, e.g., a processing chamber, transfer chamber, lock chamber, or swing module. The chamber may be a vacuum chamber. The chamber may be a vacuum deposition chamber, e.g., a sputter chamber. The chamber may include at least one substrate transfer port for substrate transfer into or out of the chamber along a transportation path. The transfer port or transfer ports may be configured to allow transfer of substrates therethrough without breaking a vacuum in the chamber. The chamber includes a transfer device for substrate transfer according to any of the embodiments described herein.

Fig. 3 shows a chamber 200 in which transfer device 100 is arranged. The chamber 200 includes a first substrate transfer port 210 at the position where the first transport path T1 crosses the chamber wall 201, and includes a second substrate transfer port 220 at the position where the second transport path T2 crosses the chamber wall 201. In Fig. 3, the first and second transport paths terminate in the chamber 200. Chamber 200 may, e.g., be the first or last chamber in an in-line substrate processing system. Transport paths T1 and T2 cross the chamber wall opposite chamber wall 201 in other embodiments, and there are further substrate transfer ports in these embodiments.

Fig. 4 shows an embodiment of chamber 200 which is configured as a substrate processing chamber. The chamber 200 includes a transfer device 100, a first substrate transfer port 210 for transferring substrates into or out of the chamber 200 along the first transport path T1, another first substrate transfer port 212 at the position where the first transport path T1 crosses a chamber wall 203 for transferring substrates into or out of the chamber 200 along the first transport path T1, a second substrate transfer port 220 for transferring substrates into or out of the chamber 200 along the second transport path T2, and another second substrate transfer port 222 at the position where the second transport path T2 crosses the chamber wall 203 for transferring substrates into or out of the chamber 200 along the second transport path T2. The chamber also includes a deposition source 250, e.g., a sputter cathode, for depositing a layer onto a substrate. A substrate processing position P is shown into which a substrate or substrate carrier is moved for coating the substrate. The processing position is typically parallel to the transport paths and different therefrom. Alternatively, the processing position might coincide with a section of one of the transport paths in the chamber, e.g., transport path T2.

Substrate support assemblies of transfer devices according to embodiments described herein may be alignable with the first and second transport paths and with the substrate processing position. For the first substrate support assembly 110 this is indicated by the three curved arrows to the left of the substrate support assembly 110, and for the second substrate support assembly 120 this is indicated by the three curved arrows to the right of the substrate support assembly 120. The first and second substrate support assemblies 110, 120 may pass each other as indicated by the two opposing arrows in the middle of the figure, so that they can be individually aligned with the first and second transport paths T1, T2 and with the processing position P. The current positions of the substrate support assemblies shown in Figs. 1-4 are randomly chosen simply for illustration.

The first substrate support assembly includes first support elements, and the second substrate support assembly includes second support elements. Support elements may generally include sets of mechanical and/or magnetic support elements. Mechanical support elements can be, e.g., rollers, belts or mechanical guiding elements such as clamps or grippers. Magnetic support elements can be, e.g., magnetic guiding elements. Support elements are configured to support substrates or substrate carriers, e.g., to hold and/or guide the substrates or substrate carriers. Some support elements may be connected to a drive or a drive system. Driven support elements, e.g., driven rollers or driven belts on which a substrate or substrate carrier stands, can impart motion to the substrate or substrate carrier in the transport direction to perform substrate transfer or aid in substrate transfer.

A substrate support assembly may include any number and type of support elements suitable to define a track for substrate support. For example, a substrate support assembly may include a belt and/or 2-20 rollers, typically 2-10 rollers, e.g., 3 or 5 rollers. The transfer device may include additional static support elements such as static rollers that will be described further below. The substrate support assembly may additionally or alternatively include 1-20 magnetic support elements, typically 2-10, more typically 5 to 9 magnetic support elements. For processing of vertically oriented substrates, the rollers and/or belt(s) may be arranged to support a bottom part of a substrate or substrate carrier. The rollers may carry the substrate or substrate carrier. The rollers or belt(s) may at least partly be driven rollers or driven belt(s), allowing active substrate movement in the transport direction. Rollers or other mechanical support elements that contact the substrate or substrate carrier are advantageously arranged at the bottom part of the substrate or substrate carrier. Particles generated due to the mechanical contact will not fall onto the substrate in this case. The magnetic support elements may be arranged to support a top part of the substrate or substrate carrier by magnetic forces. The magnetic support elements may be magnetic guiding elements to guide the top part of the substrate or substrate carrier while the substrate or substrate carrier is carried, and possibly moved, by the rollers. Magnetic support elements at least at the top part of a substrate or substrate carrier allow contactless guiding of the substrate or substrate carrier. No particles are generated which could fall onto the substrate and disadvantageously influence substrate processing.

Figs. 5-8 illustrate a transfer device and transfer system according to further embodiments, and a method how substrates are moved by the transfer device or transfer system. Fig. 5 shows a first substrate support assembly 310 which includes first support elements 312, and a second substrate support assembly 320 which includes second support elements 322. Fig. 5 and also Figs. 6-8 are schematic drawings to illustrate the working principle, so the actual number and type of support elements are not necessarily reflected in the drawings. The support elements shown may, e.g., be magnetic guiding elements.

As shown in Fig. 5, the first substrate support assembly 310 supports a substrate 50. Support is provided at least partly through the first support elements 312. The support elements 312 are moved to the process position P while supporting the substrate 50 or its carrier. The second support elements 322 of the second substrate support assembly are moved to the first transport path T1. The substrate 50 is moved and supported in its track, and there is no additional handling of the substrate or its carrier. The substrate 50 and the first support elements 312 pass the second support elements 322 on their way to the processing position P. The first and second support elements 312, 322 may move simultaneously. Alternatively, only one of the sets of support elements moves. For example, the first support elements 312 supporting substrate 50 may move to the process position P first, and then the second substrate support elements 322 move into alignment with the first transport path T1. In any case, there is relative movement between the first and second support elements in the switch direction.

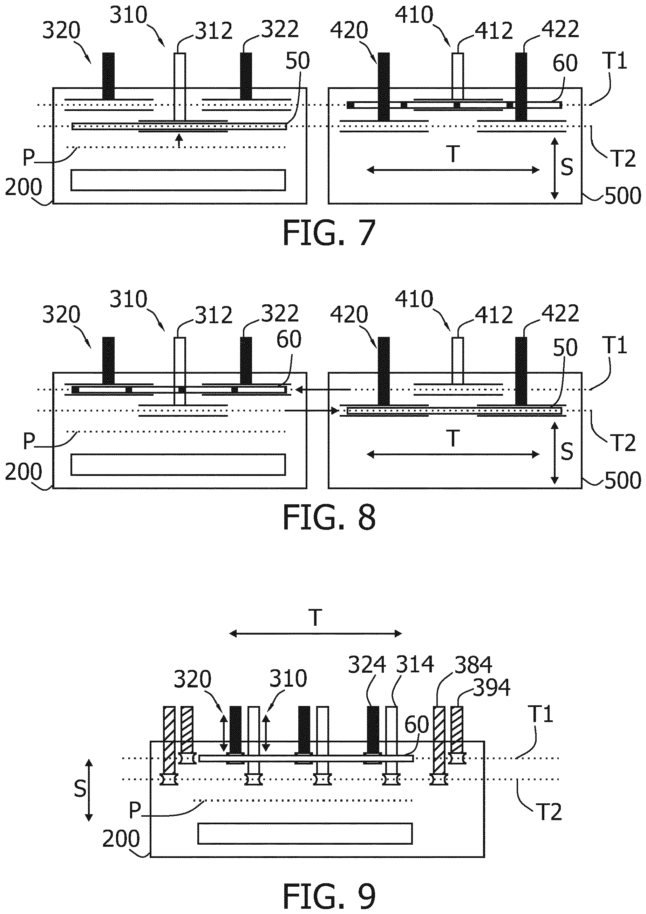

Fig. 6 shows the situation where the substrate 50 is in the processing position P and receives a coating layer from the deposition source 250. After deposition of a layer onto the substrate 50, the first support elements 312 and the substrate 50 move to the second transport path T2 as shown in Fig. 7. Fig. 7 also shows a further chamber 500, which might be another substrate processing chamber or a transfer chamber, a lock chamber, or a swing module. The further chamber 500 includes a second transfer device that may be a transfer device according to any of the embodiments described herein.

The second transfer device includes two further substrate support assemblies 410, 420, including substrate support elements 412 and 422, respectively. A second substrate 60 is supported by the substrate support elements 412 in alignment with the first transport path T1. Fig. 8 illustrates a simultaneous transfer of the first substrate 50 from chamber 200 to chamber 500 along the second transport path T2 and of the second substrate 60 from chamber 500 to chamber 200 along the first transport path T1. Support elements 422 of the previously empty support assembly 420 receive the first substrate 50 in chamber 500, and support elements 322 of the previously empty support assembly 320 receive the second substrate 60 in chamber 200. Similarly as in Figs. 5-7, the substrate processing may continue with substrate 60 being moved and coated in a similar way as previously substrate 50.

Two or more transport devices according to embodiments described herein can form a transport system for substrate transfer in or through a substrate processing system. Further embodiments relate to a transport system including at least two transport devices, relate to at least two chambers, typically vacuum chambers, including such a transport system, and relate to a substrate processing system including a transport system or including at least two chambers that include a transport system. The substrate processing system typically is a vacuum substrate processing system, e.g. an inline vacuum substrate processing system. Chambers of a substrate processing system may be connected to each other in vacuum-tight fashion, and may include corresponding substrate transfer ports for transferring substrates into or out of the chambers wherein the transfer ports may be connected by locks. Substrate processing systems are described in the PCT application entitled "Substrate Processing System and Method of Processing Substrates", filed on the same day and assigned to the same assignee, attorney docket number 17507P-WO, the content of which is incorporated by reference in its entirety.

A transport device according to embodiments described herein may include more than two substrate support assemblies, e.g., three, four, five or more than five substrate support assemblies. In typical embodiments, the transport device has exactly two substrate support assemblies. Such a transport device is called a dual-track switching transport device, in contrast to the rigid triple and dual track devices of WO 2009/156196 A1. A chamber including a dual-track switching transport device is called a dual-track switching chamber. A transport system including only dual-track transport devices (switchable or rigid) is called a dual-track transport system, and a substrate processing system including only dual-track chambers or including a dual-track transport system is called a dual-track substrate processing system. If the dual-track transport system or dual-track substrate processing system includes at least one dual-track switching transport device, it is called a dual-track switching transport system or dual-track switching substrate processing system.

Fig. 9 shows a transport device including a first substrate support assembly 310 and second substrate support assembly 320, both being movable independently of each other in the switch direction S as indicated by the double-headed arrows to the left of assembly 320 and to the right of assembly 310. The first substrate support assembly 310 includes first support elements including a first set of rollers 314, and the second substrate support assembly 320 includes second support elements including a second set of rollers 324. The first and second sets of rollers 314, 324 are moveable in the switch direction. A substrate 60 is supported by the rollers 324 in Fig. 9.

The transport device may additionally include static support elements that are not movable in the switch direction, e.g., static rollers. The transport device may include, e.g., 1-10 static rollers per track, typically 2-4 static rollers per track, such as 2 static rollers per track. Static rollers may be driven rollers. Fig. 9 shows two first static rollers 394 in alignment with the first transport path T1, and two second static rollers 384 in alignment with the second transport path T2. For instance, the substrate 60 may have entered the chamber from the right along the transport direction T through a corresponding substrate transfer port, passed over roller(s) 394 to be now supported by the rollers 324.

The rollers 314 and 324 of Fig. 9 may be moved in a way similar to that shown in Figs. 5-8. In particular, the rollers 314, 324 can pass each other in the switch direction S, even if one set of rollers, e.g., set of rollers 324, supports a substrate. While Figs. 5-8 schematically illustrate any kind of support elements, assume as an example that magnetic guiding elements are represented by the set of support elements 312 and 322, and that they support a top part of a vertically oriented substrate or substrate carrier. Then the view of chamber 200 of Fig. 8 can be considered as a horizontal cut through the chamber 200 in a plane through top parts of the substrate 60 or its carrier. Fig. 9 could then represent a horizontal cut through the same chamber 200 in lower plane through bottom parts of the substrate 60 or its carrier.

According to some embodiments, the support elements of one support assembly may be moved in the switch direction as a group. The track defined by the support elements of one support assembly is then lying in a plane whose normal substantially is the switch direction. A substrate or substrate carrier can thus be moved on a track substantially without tilt, e.g., with a tilt of at most 10° or at most 7°.

When an empty substrate support assembly, i.e., a substrate support assembly currently not supporting a substrate or substrate carrier, and a loaded substrate support assembly, i.e., a substrate support assembly currently supporting a substrate or substrate carrier, pass each other in the switch direction, three situations may occur. The empty substrate support assembly, respectively its support elements, may be able to pass both the substrate and the support elements of the loaded substrate support assembly without collision. Typically, however, the support elements of the empty substrate support assembly would collide with the substrate and/or with the substrate support elements of the loaded substrate support assembly upon trying to pass the latter in the switch direction. Then, the support elements of the empty substrate support assembly can perform an evasion movement to avoid such a collision. If the support elements of both support assemblies could pass each other without collision if they were both empty, e.g., because they are offset with respect to each other, then the evasion movement only needs to avoid a collision with the substrate. Otherwise, both a collision with the substrate and with the support elements of the loaded substrate support assembly needs to be avoided.

According to further embodiments, the first substrate support assembly includes first support elements, the second substrate support assembly includes second support elements, and at least part of the first support elements and at least part of the second support elements are moveable relative to each other in an evasion direction. The evasion direction is perpendicular to the transport direction and perpendicular to the switch direction. For vertically or substantially vertically oriented substrates or substrate carriers, the evasion direction is the vertical direction. The relative motion in the evasion direction is enabled at least during relative movement of the first substrate support assembly and the second substrate support assembly in the switch direction. The first support elements of the first substrate support assembly and the second support elements of the second substrate support assembly may be moveable relatively to each other both in the switch direction and in the evasion direction.

The first support elements, or at least parts thereof, may moveable in the evasion direction. Additionally or alternatively, the second support elements, or at least parts thereof, may be moveable in the evasion direction. The first and second support elements, or at least respective parts thereof, may be moveable independently of each other in the evasion direction.

For the evasion movement, support elements may be configured to be tilted or pivoted. The support elements may take up a displacement in the evasion direction through tiling or pivoting. Therein, the amount of displacement by tilting or pivoting may be such that the tilted or pivoted support elements can either pass a substrate supported by a loaded support assembly or pass the support elements of the loaded support assembly or both, depending upon need as described above. Typically, an evasion movement for avoiding only collision with the substrate needs less displacement by tilting or pivoting as compared to a movement for avoiding collision with the support elements of the loaded substrate support assembly. The amount of tilting or pivoting, and therefore the amount of displacement in the evasion direction is determined accordingly.

The first support elements and second support elements can be dimensioned such that they can pass each other without collision when moved in the switch direction in the absence of a substrate. In this way, the evasion movement can be made smaller, requiring less tilting or pivoting. Alternatively, the first support elements and second support elements can be dimensioned such that they collide when moved in the switch direction in the absence of a substrate. This allows larger dimensions of the support elements in the transport direction, which can be particularly advantageous for guiding elements such as magnetic guiding elements.

The first support elements may include a first set of upper support elements. Upper support elements are configured to support an upper part of a substantially vertically oriented substrate or substrate carrier. The second support elements may include a second set of upper support elements. The first support elements may include a first set of lower support elements. Lower support elements are configured to support a lower part of a substantially vertically oriented substrate or substrate carrier. The second support elements may include a second set of lower support elements. Upper support elements may, e.g., be magnetic support elements such as magnetic guiding elements, or may be mechanical support elements such as rollers. Lower support elements may, e.g., be mechanical support elements such as rollers or belts. The upper and/or lower support elements may be pivotable or tiltable.

The first support elements may include a first set of magnetic support elements and the second support elements may include a second set of magnetic support elements. At least one of the first and second sets of magnetic support elements may be configured to be pivoted or tilted for taking up a displacement in the evasion direction relative to the respective other set of magnetic support elements. The first support elements may include a first set of roller support elements. The second support elements may include a second set of roller support elements. At least one of the first and second set of roller support elements may be configured to be pivoted or tilted for taking up a displacement in the evasion direction relative to the respective other set of roller support elements.

The first and second sets of magnetic support elements may be arranged to support top parts of substantially vertically oriented substrates or substrate carriers by magnetic forces, i.e., they may be upper support elements. The first and second sets of roller support elements may be arranged to support bottom parts of substantially vertically oriented substrates or substrate carriers, i.e., they may be lower support elements. The evasion direction is the vertical direction for vertically oriented substrates or substrate carriers. The first and second sets of magnetic support elements are adapted to be raised, i.e., moved up along the vertical direction, and the first and second sets of roller support elements are adapted to be lowered, i.e., moved down along the vertical direction. The up and down motion are such that the first set of magnetic support elements and the first set of roller support elements, when holding a substrate or substrate carrier, can be passed by the second set of magnetic support elements and the second set of roller support elements during relative movement of the first and second substrate support assemblies in the switch direction. The up and down motion are such that the second set of magnetic support elements and the second set of roller support elements, when holding a substrate or substrate carrier, can be passed by the first set of magnetic support elements and the first set of roller support elements during relative movement of the first and second substrate support assemblies in the switch direction.

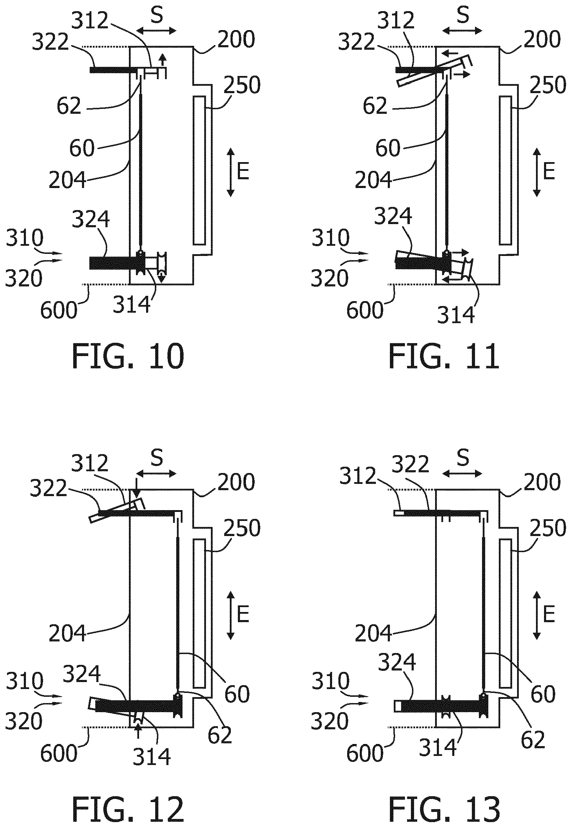

Figs. 10-13 schematically illustrate an evasion movement by tilting. The example shown relates to a vertically aligned substrate 60 and substrate carrier 62. The example can be considered as a specific embodiment realizing a movement of substrate 60 similar to the movement of substrate 50 shown in Figs. 5 and 6. The tilting angles and other dimensions are exaggerated for illustration.

Fig. 10 shows a vacuum chamber 200 including a deposition source 250. The vacuum chamber 200 has a wall 204 opposite the deposition source 250. A transport device includes first and second substrate support assemblies 310, 320. The first substrate support assembly 310 includes a set of rollers 314 and a set of magnetic guiding elements 312. The second substrate support assembly 320 includes a set of rollers 324 and a set of magnetic guiding elements 322, which currently support the substrate carrier 62 that is holding the substrate 60. Axes of the rollers extend through openings in the wall 204 of the vacuum chamber 200 into a non-vacuum region 600. Seals such as bellow seals may for example be provided at the points where the axes run through the wall 204. The seals may seal the openings in a vacuum-tight way. The openings and seals are dimensioned to allow tilting of the axes. The openings and seals may be dimensioned to allow tilted movement of the axes in the switch direction S.

Substrate 60 in its carrier 62 is in alignment with the first transport path in Fig. 10. For instance, substrate 60 and substrate carrier 62 may have been transferred into the chamber along the first transport path, e.g., similarly as shown in Fig. 8. The currently empty support elements 312 and 314 of the first substrate support assembly are moved in the evasion direction E by tilting the axes on which they reside. As a general feature, the center of rotation for a tilting movement may be located in each opening in a chamber wall through which axes of support elements go. In the embodiment shown in Fig. 10, the magnetic guiding element(s) 312 are moved upwards, and the roller elements 314 are moved downwards, leading to the situation shown in Fig. 11.

In the embodiment shown in Figs. 10-13, the rollers 314 and 324 could pass each other without collision if no substrate was in the chamber. As shown in Fig. 11, the rollers 314 are tilted only so far that they can pass under the lowest part of the carrier 62. The magnetic guiding elements 312 and 322 would not be able to pass each other in the untilted state without collision even if there was no substrate in the chamber. They are tilted so far that they can pass each other, which, as shown in Fig. 11, may require a larger tilting angle as compared to the situation where only collision with the uppermost part of the substrate carrier 62 would have to be avoided.

Tilting angles α depend on the desired displacement e and the length 1 between the center of rotation and the point of the support element that is to assume a displaced position to allow passing of other support elements, namely sinα=e/l. Tilting angles may be, e.g., from 0.5° to 20°. Tilting angles may be from 1° to 5° for support elements at the bottom of substrates or substrate carriers, typically from 2° to 4°, e.g., about 2.5°. Tilting angles may be from 10° to 20° for support elements at the top of substrates or substrate carriers, typically from 12° to 16°, e.g. about 14°.

The first substrate support assembly 310 with tilted support elements 312 and 314 is moved in the switch direction S towards the wall 204 as shown in Fig. 11, and the second substrate support assembly 320 with the support elements 322 and 324 supporting substrate carrier 62 is moved in the switch direction S towards the deposition source 250. In Fig. 12, the substrate carrier 62 and substrate 60 have been moved to the processing position while being supported by the second track. The tilted support elements 312 and 314 can be un-tilted, i.e., their axes can be brought back into a horizontal position once they have passed the substrate 60 and support elements 322, 324 of the second substrate support assembly 320. Fig. 13 shows the situation where the first track is aligned with the first transport path, and the second track with the substrate 60 is aligned with the processing position. The first track defined by the first substrate support assembly 310 and the second track defined by the second substrate support assembly 320 have passed each other. After processing the substrate is complete, the substrate 60 and substrate carrier 62 could be moved to the left into alignment with the second transport path, whereupon an exchange of substrates with a neighboring chamber could take place, similarly as in Figs. 7 and 8.

Alternatively, tilted support elements may not be moveable. In such embodiments, empty support elements would be tilted, a loaded substrate support assembly would pass them, then the empty support elements would be un-tilted and optionally be moved thereafter. Especially when the center of rotation for the tilting movement resides in the openings in the chamber wall 204 as shown in Fig. 11, the diameter of the openings in the wall 204 and the necessary tolerance provided by vacuum seals is reduced as compared to embodiments allowing movement in the tilted state. This makes it easier to maintain the vacuum conditions. Embodiments allowing movement in the tilted state might complete a motion pattern faster, possibly leading to faster processing tact depending on how the process is conducted.

A tiltable support element may include a substrate support part, e.g., the actual roll of a roller or the actual magnetic head of a magnetic guiding element, and a shaft connected to the support part. The support element may further include a shaft, e.g. a ball spline shaft, and a ball spline bushing with bearings. The support element may include an excenter arranged on the shaft for providing a deviation that is turned into the tilt. The excenter may include a drive shaft that can be driven by an excenter drive. The support element may include seals, e.g., membrane bellow seals and/or ferro seals, which may be vacuum-tight.

An advantage of tilting a support element is that no additional mechanism is needed in the vacuum chamber, and mechanical components necessary for tilting can be arranged outside in non-vacuum region. A further advantage, in particular for support elements arranged above the substrate, is that no mechanical interaction between any parts of the support element takes place which could generate particles that could fall onto the substrate.

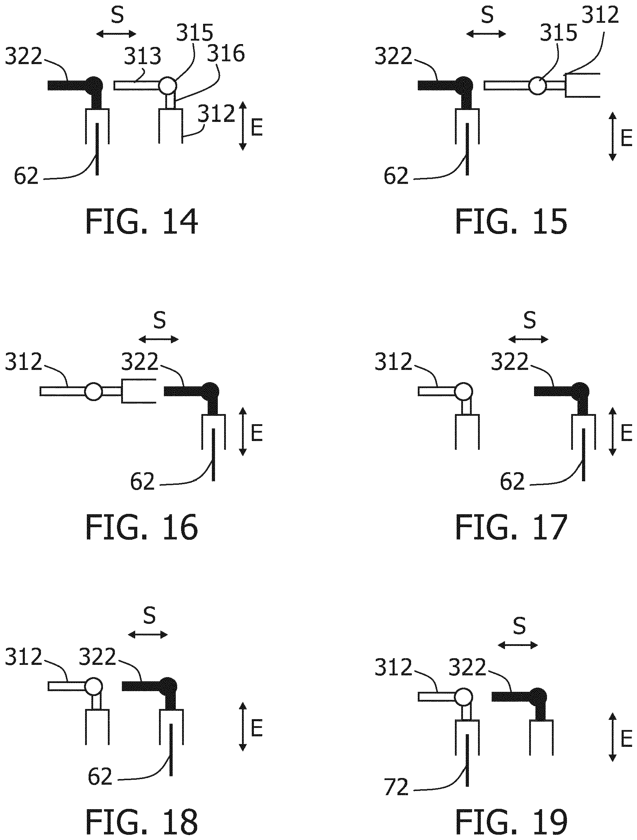

Figs. 14-19 show an embodiment in which magnetic guiding elements 322 and 312 are pivotable. Magnetic guiding elements 322 and 312 are adapted to support top parts of substrate carriers, such as substrate carriers 62 and 72. In Figs. 14-19, the support elements in form of the magnetic guiding elements are pivotable around a pivot point in the switch direction S. However, they could alternatively be pivotable in the transport direction, i.e., into or out of the plane of drawing, if space between neighboring support elements of the same substrate support assembly permits.

In Fig. 14, magnetic guiding element 322 contributes to supporting a substrate carrier 62 on a second track, while magnetic guiding element 312 belongs to a currently empty first substrate support assembly that defines a first track. The first magnetic guiding element 312 includes a shaft 313 leading through an opening in a chamber wall into an adjacent non-vacuum region, a pivot point 315, and a bar 316 connected to the shaft 313 via the pivot point 315. The bar 316 has an orientation perpendicular to the shaft 313 in Fig. 14, such that the magnetic guiding element can support a top part of a vertically oriented substrate carrier. The pivot point 315 may be a ball joint or similar component. The second magnetic guiding element 322 may be similarly formed.

The magnetic guiding element 312 may be pivoted, meaning that its bar 316 is pivoted around pivot point 315. In Fig. 15, the bar 316 is pivoted by 90° into alignment with the shaft 313. Pivoting angles may, e.g., be from 45° to 110°, more typically from 80° to 100°, e.g., about 90°. This movement in the evasion direction E relative to the second magnetic guiding element 322 displaces the first magnetic guiding element 312 in the evasion direction. As shown in Fig. 16, the displacement is such that a relative motion in the switch direction between the first magnetic guiding element 312 on the one side and the second magnetic guiding element 322 and substrate carrier 62 on the other side is possible without collision. The support elements in form of the first and second magnetic guiding elements may pass each other in the switch direction.

The magnetic guiding element 312 may then be un-pivoted or pivoted back so that the bar 316 and shaft 313 again form a right angle, and the first magnetic guiding element 312 is ready to receive a substrate carrier. For instance, a substrate held by the carrier 62 may be in a processing position in Fig. 17, and then moved to a second transport path in Fig. 18. The carrier 62 with its substrate is then transferred to a second chamber, and a different carrier 72 with its substrate is simultaneously or subsequently received on the first transport path from the second chamber or from another, third chamber. The situation in Fig. 19 is similar to that of Fig. 14, only with the first and second substrate support assemblies and corresponding magnetic guiding elements exchanged.

Support elements may be connected to individual transversal drives or a transversal drive system for movement in the switch direction. Driven support elements, which are able to move a substrate or substrate carrier in the transport direction, may be connected to individual drives or to a drive system for substrate transport into or out of a chamber, such as a belt system. Tiltable support elements may be connected to individual excenter drives or an excenter drive system for providing the tilting movement. All these drives may be controlled by a control system. The movements of the support elements and the entire process conduct of substrate processing may be controlled by the control system in a fully automatic way.

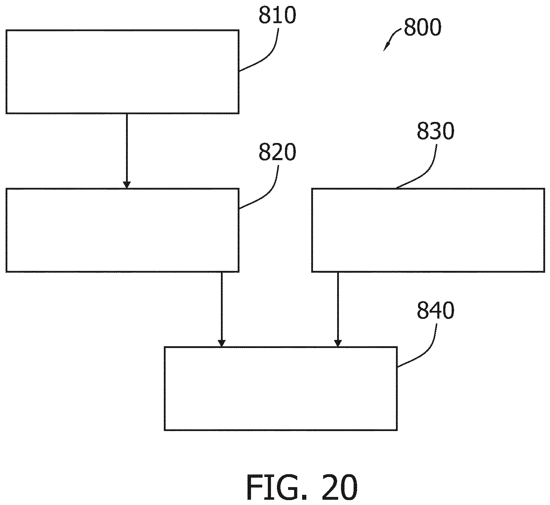

According to further embodiments, as shown in Fig. 20, a method of moving a substrate in a substrate processing system, 800, is provided. The method may be performed by a transport device, a transport system, a chamber or a substrate processing system according to any of the embodiments described herein.

The method includes transferring the substrate into a chamber along a first transport path, step 810. The first transport path may be along a transport direction, and the substrate is transferred into the chamber along the transport direction. The method includes moving the substrate in the chamber at least in a switch direction perpendicular to the first transport path, step 820.

The method includes moving support elements of an empty substrate support assembly in the chamber, step 830. Movement of the support elements of the empty substrate support assembly may include a movement in an evasion direction. The evasion direction is perpendicular to the first transport path, respectively the transport direction, and perpendicular to the switch direction. Movement of the support elements of the empty substrate support assembly may additionally or alternatively include a movement in the switch direction.

According to the method of embodiments described herein, the substrate and the support elements of the empty substrate support assembly are moved relatively to each other in the switch direction, step 840. The substrate and the support elements may pass each other.

Transferring the substrate into the chamber may include transferring the substrate into the chamber so as to be supported by a first track defined by first support elements of a first substrate support assembly. The empty substrate support assembly is a second substrate support assembly and the support elements of the empty substrate support assembly are second support elements in such embodiments. The second, empty substrate support assembly, respectively its support elements, define(s) a second track. In these embodiments, moving the substrate includes moving the first track supporting the substrate, i.e., moving the first track while it is supporting the substrate. The first track supporting the substrate and the second track may be moved relatively to each other in the switch direction and may pass each other.

The method may include pivoting or tilting at least part of the second support elements. The method may include pivoting or tilting at least part of the first support elements. Pivoting and tilting may be performed as described hereinbefore, e.g., with respect to Figs. 10-19.

The chamber may be a substrate processing chamber having a substrate processing position. Moving the substrate may include moving the substrate to the substrate processing position. The method may include depositing a layer on the substrate in the processing position.

The method may further include transferring the substrate out of the chamber along a second transport path. Simultaneously or subsequently, a second substrate may be transferred into the chamber along the first transport path. The second substrate may be received by the support elements of the empty substrate support assembly. The substrate exchange between different chambers may be performed as previously described herein, e.g., with respect to Figs. 7-8 and 18-19.

According to a further embodiment, a method of moving substrates in a vacuum processing system is provided. The method includes transferring a first substrate into a vacuum chamber along a first transport path, moving a first substrate support assembly in the vacuum chamber in a switch direction perpendicular to the first transport path to move the first substrate into a vacuum process position. The method includes moving a second substrate support assembly in the vacuum chamber opposite to the switch direction to receive a second substrate while the first substrate is in the vacuum process position. The method further includes moving the second substrate support assembly in the vacuum chamber in the switch direction to move the second substrate into the vacuum process position.

The terms and expressions which have been employed herein are used as terms of description and not of limitation, and there is no intention, in the use of such terms and expressions, of excluding any equivalents of the features shown and described or portions thereof. While the foregoing is directed to embodiments, other and further embodiments may be devised without departing from the scope, and the scope is determined by the claims that follow.

## Claims

1. A transfer device (100) for substrate transfer along a transport direction (T) and for change between a first transport path (T1) and a second transport path (T2) extending along the transport direction, wherein the first transport path is displaced with respect to the second transport path in a switch direction (S) perpendicular to the transport direction, the transfer device comprising:
a first substrate support assembly (110) defining a first track to support a substrate or substrate carrier in a chamber, wherein the first substrate support assembly includes first support elements (312);
a second substrate support assembly (120) defining a second track to support a substrate or substrate carrier in the chamber, wherein the second substrate support assembly includes second support elements (322), **characterized in that** the first substrate support assembly and the second substrate support assembly are moveable relative to each other at least in the switch direction.

2. The transfer device according to claim 1, wherein
the first substrate support assembly is moveable at least in the switch direction, wherein the first track is alignable with the first transport path and alternatively with the second transport path; and
the second substrate support assembly is moveable at least in the switch direction, wherein the second track is alignable with the first transport path and alternatively with the second transport path.

3. The transfer device according to claim 1 or 2, wherein the first substrate support assembly and the second substrate support assembly are moveable relative to each other wherein the first track and the second track pass each other in the switch direction.

4. The transfer device according to any one of claims 1 to 3, wherein
the first substrate support assembly comprises first support elements (310); and
the second substrate support assembly comprises second support elements (320),
wherein at least part of the first support elements and at least part of the second support elements are moveable relative to each other in an evasion direction (E) perpendicular to both the transport direction and the switch direction.

5. The transfer device according to claim 4, wherein
the first support elements comprise a first set of magnetic support elements (312); and
the second support elements comprise a second set of magnetic support elements (322),
wherein at least one of the first and second sets of magnetic support elements is configured to be pivoted or tilted for taking up a displacement in the evasion direction relative to the respective other set of magnetic support elements.

6. The transfer device according to claim 5, wherein
the first support elements comprise a first set of roller support elements (314); and
the second support elements comprise a second set of roller support elements (324),
wherein at least one of the first and second set of roller support elements is configured to be pivoted or tilted for taking up a displacement in the evasion direction relative to the respective other set of roller support elements.

7. The transfer device according to claim 6 , wherein the first and second sets of magnetic support elements are arranged to support top parts of substantially vertically oriented substrates (50, 60) or substrate carriers (52, 62) by magnetic forces, and the first and second sets of roller support elements are arranged to support bottom parts of substantially vertically oriented substrates (50, 60) or substrate carriers (52, 62), and wherein the first and second sets of magnetic support elements are adapted to be raised and the first and second sets of roller support elements are adapted to be lowered, wherein the first sets of magnetic and roller support elements (312, 314), when holding a substrate (50) or substrate carrier (52), can be passed by the second sets of magnetic and roller support elements (322, 324) during relative movement of the first and second substrate support assemblies (310, 320) in the switch direction, and vice versa.

8. A chamber (200) for a substrate processing system, comprising:
at least one first substrate transfer port (210, 212) for substrate transfer into our out of the chamber along a first transport path (T1),
at least one second substrate transfer port (220, 222) for substrate transferring into or out of the chamber along a second transport path (T2); and
a transfer device (100) according to any one of claims 1 to 7, the transfer device being arranged in the chamber.

9. The chamber of claim 8, wherein the chamber is a substrate processing chamber for deposition of a layer onto a substrate,
wherein a substrate processing position (P) is located in the substrate processing chamber, the substrate processing position either being located remote from the first and second transport paths or being located on one of the first or second transport paths, and wherein the first and second tracks are individually alignable with the substrate processing position.

10. A method of moving a substrate (50) in a substrate processing system, the method comprising:
transferring the substrate (50) into a chamber (200) along a first transport path (T1);
moving the substrate in the chamber at least in a switch direction (S) perpendicular to the first transport path (T1); and
moving support elements (322, 324) of an empty substrate support assembly (320) in the chamber, **characterized in that** the substrate (50) and the support elements (322, 324) of the empty substrate support assembly are moved relatively to each other in the switch direction and pass each other.

11. The method according to claim 10, wherein the movement of the support elements of the empty substrate support assembly includes at least one of the following:
a movement in an evasion direction (E) perpendicular to both the first transport path and the switch direction, and
a movement in the switch direction.

12. The method according to claim 10 or 11, wherein transferring the substrate comprises transferring the substrate to be supported by a first track defined by first support elements (312, 314) of a first substrate support assembly (310), wherein the empty substrate support assembly is a second substrate support assembly and the support elements of the empty substrate support assembly are second support elements defining a second track, wherein moving the substrate comprises moving the first track supporting the substrate; and
wherein the first track supporting the substrate and the second track defined by the second support elements are moved relatively to each other in the switch direction and pass each other.

13. The method according to claim 12, comprising
pivoting or tilting at least part of the second support elements (322, 324).

14. The method according to any one of claims 10 to 13, wherein the chamber has a processing position (P), and wherein moving the substrate comprises moving the substrate to the processing position, the method further comprising:
depositing a layer on the substrate in the processing position.

15. The method according to any one of claims 10 tol4, further comprising:
transferring the substrate out of the chamber along a second transport path (T2); and
simultaneously transferring a second substrate (60) into the chamber along the first transport path (T1), wherein the second substrate is received by the support elements (322, 324) of the empty substrate support assembly (320).

## Patentansprüche

1. Übertragungsvorrichtung (100) für die Substratsübertragung einer Transportrichtung (T) entlang und zur Änderung zwischen einem ersten Transportweg (T1) und einem zweiten Transportweg (T2), der sich der Transportrichtung entlang erstreckt, wobei der erste Transportweg mit Bezug auf den zweiten Transportweg in einer Umschaltrichtung (S) senkrecht zur Transportrichtung verschoben ist, wobei die Übertragungsvorrichtung Folgendes umfasst:
eine erste Substratstützanordnung (110), die eine erste Bahn zum Stützen eines Substrats oder Substratträgers in einer Kammer definiert, wobei die erste Substratstützanordnung erste Stützelemente (312) umfasst;
eine zweite Substratstützanordnung (120), die eine zweite Bahn zum Stützen eines Substrats oder Substratträgers in der Kammer definiert, wobei die zweite Substratstützanordnung zweite Stützelemente (322) umfasst;
**dadurch gekennzeichnet, dass**
die erste Substratstützanordnung und die zweite Substratstützanordnung mit Bezug aufeinander in mindestens der Umschaltrichtung beweglich sind.

2. Übertragungsvorrichtung nach Anspruch 1, wobei
die erste Substratstützanordnung mindestens in der Umschaltrichtung beweglich ist,
wobei die erste Bahn auf den ersten Transportweg und alternativ den zweiten Transportweg ausrichtbar ist; und
die zweite Substratstützanordnung mindestens in der Umschaltrichtung beweglich ist,
wobei die zweite Bahn auf den zweiten Transportweg und alternativ den ersten Transportweg ausrichtbar ist.

3. Übertragungsvorrichtung nach Anspruch 1 oder 2, wobei die erste Substratstützanordnung und die zweite Substratstützanordnung mit Bezug aufeinander beweglich sind, wobei die erste Bahn und die zweite Bahn aneinander in der Umschaltrichtung vorbeigehen.

4. Übertragungsvorrichtung nach einem der Ansprüche 1 bis 3, wobei
die erste Substratstützanordnung erste Stützelemente (310) umfasst; und
die zweite Substratstützanordnung zweite Stützelemente (320) umfasst,
wobei mindestens ein Teil der ersten Stützelemente und mindestens ein Teil der zweiten Stützelemente mit Bezug aufeinander in einer Ausweichrichtung (E) senkrecht zu sowohl der Transportrichtung als auch der Umschaltrichtung beweglich sind.

5. Übertragungsvorrichtung nach Anspruch 4, wobei
die ersten Stützelemente einen ersten Satz magnetischer Stützelemente (312) umfassen; und
die zweiten Stützelemente einen zweiten Satz magnetischer Stützelemente (322) umfassen,
wobei mindestens eines von den ersten und zweiten Sätzen magnetischer Stützelemente so konfiguriert ist, dass es zum Aufgreifen einer Verschiebung in der Ausweichrichtung mit Bezug auf den jeweiligen anderen Satz magnetischer Stützelemente gedreht oder geneigt werden soll.

6. Übertragungsvorrichtung nach Anspruch 5, wobei
die ersten Stützelemente einen ersten Satz Rollenstützelemente (314) umfasst; und
die zweiten Stützelemente einen zweiten Satz Rollenstützelemente (324) umfasst,
wobei mindestens eines von dem ersten und zweiten Satz Rollenstützelemente so konfiguriert ist, dass es zum Aufgreifen einer Verschiebung in der Ausweichrichtung mit Bezug auf den jeweiligen anderen Satz Rollenstützelemente gedreht oder geneigt werden soll.

7. Übertragungsvorrichtung nach Anspruch 6, wobei die ersten und zweitens Sätze magnetischer Stützelemente angeordnet sind, um obere Teile von im Wesentlichen senkrecht orientierten Substraten (50, 60) oder Substratträgern (52, 62) durch magnetische Kräfte zu stützen und die ersten und zweitens Sätze Rollenstützelemente angeordnet sind, um untere Teile von im wesentlichen senkrechtorientierten Substraten (50, 60) oder Substratträgern (52, 62) zu stützen, und
wobei die ersten und zweitens Sätze magnetischer Stützelemente geeignet sind, hochgehoben zu werden und die ersten und zweitens Sätze Rollenstützelemente geeignet sind, gesenkt zu werden,
wobei die ersten Sätze magnetischer und Rollenstützelemente (312, 314), halten sie ein Substrat (50) oder einen Substratträger (52), durch die zweitens Sätze magnetischer Rollenstützelemente (322, 324) während der relativen Bewegung der ersten und zweiten Substratstützanordnungen (310, 320) in einer Umschaltrichtung, und umgekehrt, überholt werden können.

8. Kammer (200) für ein Substratbearbeitungssystem, umfassend:
mindestens eine erste Substratübertragungsöffnung (210, 212) für die Substratsübertragung in die oder aus der Kammer einem ersten Transportweg (T1) entlang,
mindestens eine zweite Substratübertragungsöffnung (220, 222) für die Substratsübertragung in die oder aus der Kammer einem zweiten Transportweg (T2) entlang; und
eine Übertragungsvorrichtung (100) nach irgendeinem der Ansprüche 1 bis 7, wobei die Übertragungsvorrichtung in der Kammer angeordnet ist.

9. Kammer nach Anspruch 8, wobei die Kammer eine Substratbearbeitungskammer für das Absetzen einer Schicht auf das Substrat ist,
wobei eine Substratsbearbeitungsposition (P) sich in der Substratsbearbeitungskammer befindet, wobei die Substratsbearbeitungsposition sich entweder von den ersten und zweiten Transportwegen entfernt befindet oder sich auf einem der ersten oder zweiten Transportwege befindet und wobei die ersten und zweiten Bahnen einzeln auf die Substratsbearbeitungsposition ausrichtbar sind.

10. Verfahren zum Bewegen eines Substrats (50) in einem Substratbearbeitungssystem, wobei das Verfahren Folgendes umfasst:
das Übertragen des Substrats (50) in eine Kammer (200) einem ersten Transportweg (T1) entlang;
das Bewegen des Substrats in der Kammer zumindest in einer Umschaltrichtung (S) senkrecht zu dem ersten Transportweg (T1); und
das Bewegen von Stützelemente (322, 324) einer leeren Substratstützanordnung (320) in der Kammer,
**dadurch gekennzeichnet, dass**
das Substrat (50) und die Stützelemente (322, 324) der leeren Substratstützanordnung mit Bezug aufeinander in der Umschaltrichtung bewegt werden und aneinander vorbeigehen.

11. Verfahren nach Anspruch 10, wobei die Bewegung der Stützelemente der leeren Substratstützanordnung mindestens eines der Folgenden umfasst:
eine Bewegung in einer Auswegrichtung (E) senkrecht zu sowohl dem ersten Transportweg als auch der Umschaltrichtung, und
eine Bewegung in der Umschaltrichtung.

12. Verfahren nach Anspruch 10 oder 11, wobei das Übertragen des Substrats das Übertragen des Substrats umfasst, das durch eine erste Bahn gestützt werden soll, die durch erste Stützelemente (312, 314) einer ersten Substratstützanordnung (310) definiert ist, wobei die leere Substratstützanordnung eine zweite Substratstützanordnung ist und die Stützelemente der leeren Substratstützanordnung zweite Stützelemente sind, die eine zweite Bahn definieren, wobei das Bewegen des Substrats das Bewegen der ersten Bahn, die das Substrat unterstützt, umfasst; und
wobei die erste Bahn, die das Substrat stützt, und die zweite Bahn, die durch die zweiten Stützelemente definiert ist, mit Bezug aufeinander in der Umschaltrichtung bewegt werden und aneinander vorbeigehen.

13. Verfahren nach Anspruch 12, umfassend
das Drehen oder Neigen mindestens eines Teils der zweiten Stützelemente (322, 324).

14. Verfahren nach irgendeinem der Ansprüche 10 bis 13, wobei die Kammer eine Bearbeitungsposition (P) aufweist und wobei das Bewegen des Substrats das Bewegen des Substrats zu der Bearbeitungsposition umfasst, wobei das Verfahren ferner Folgendes umfasst:
das Absetzen einer Schicht auf dem Substrat in der Bearbeitungsposition.

15. Verfahren nach irgendeinem der Ansprüche 10 bis 14, ferner Folgendes umfassend:
das Übertragen des Substrats aus der Kammer einem zweiten Transportweg (T2) entlang; und
das gleichzeitige Übertragen eines zweiten Substrats (60) in die Kammer dem ersten Transportweg (T1) entlang, wobei das zweiter Substrat durch die Stützelemente (322, 324) der leeren Substratstützanordnung (320) aufgenommen wird.

## Revendications

1. Dispositif de transfert (100) pour le transfert d'un substrat le long d'une direction de transport (T) et pour le changement entre un premier chemin de transport (T1) et un second chemin de transport (T2) s'étendant le long de la direction de transport, dans lequel le premier chemin de transport est déplacé par rapport au second chemin de transport dans une direction de commutation (S) perpendiculaire à la direction de transport, le dispositif de transfert comprenant :
un premier assemblage de support de substrat (110) définissant une première piste pour supporter un substrat ou un support de substrat dans une chambre, où le premier assemblage de support de substrat comprend des premiers éléments de support (312) ;
un second assemblage de support de substrat (120) définissant une seconde piste pour supporter un substrat ou un support de substrat dans la chambre, où le second assemblage de support de substrat comprend des seconds éléments de support (322),
**caractérisé en ce que**
le premier assemblage de support de substrat et le second assemblage de support de substrat sont amovibles relativement l'un à l'autre au moins dans la direction de commutation.

2. Dispositif de transfert selon la revendication 1, dans lequel
le premier assemblage de support de substrat est amovible au moins dans la direction de commutation,
où la première piste peut être alignée avec le premier chemin de transport et en alternance avec le second chemin de transport ; et
le second assemblage de support de substrat est amovible au moins dans la direction de commutation,
où la seconde piste peut être alignée avec le premier chemin de transport et en alternance avec le second chemin de transport.

3. Dispositif de transfert selon la revendication 1 ou 2, dans lequel le premier assemblage de support de substrat et le second assemblage de support de substrat sont amovibles relativement l'un à l'autre où la première piste et la seconde piste passent l'une l'autre dans la direction de commutation.

4. Dispositif de transfert selon l'une quelconque des revendications 1 à 3, dans lequel
le premier assemblage de support de substrat comprend les premiers éléments de support (310) ; et
le second assemblage de support de substrat comprend les seconds éléments de support (320),
où au moins une partie des premiers éléments de support et au moins une partie des seconds éléments de support sont amovibles relativement les uns aux autres dans une direction d'évasion (E) perpendiculaire aux deux direction de transport et direction de commutation.

5. Dispositif de transfert selon la revendication 4, dans lequel
les premiers éléments de support comprennent un premier ensemble d'éléments de support magnétiques (312) ; et
les seconds éléments de support comprennent un second ensemble d'éléments de support magnétiques (322),
où au moins un des premier et second ensembles d'éléments de support magnétiques est configuré pour être pivoté ou incliné pour effectuer un déplacement dans la direction d'évasion relativement à l'autre ensemble respectif d'éléments de support magnétiques.

6. Dispositif de transfert selon la revendication 5, dans lequel
les premiers éléments de support comprennent un premier ensemble d'éléments de support de rouleau (314) ; et
les seconds éléments de support comprennent un second ensemble d'éléments de support de rouleau (324),
où au moins un des premier et second ensembles d'éléments de support de rouleau est configuré pour être pivoté ou incliné pour effectuer un déplacement dans la direction d'évasion relativement à l'autre ensemble respectif d'éléments de support de rouleau.

7. Dispositif de transfert selon la revendication 6, dans lequel le premier et second ensembles d'éléments de support magnétiques sont disposés pour supporter des parties supérieures de substrats essentiellement orientés verticalement (50, 60) ou des supports de substrat (52, 62) par des forces magnétiques, et le premier et second ensemble d'éléments de support de rouleau sont disposés pour supporter les parties inférieures de substrats essentiellement orientés verticalement (50, 60) ou des supports de substrat (52, 62), et
où les premier et second ensembles d'éléments de support magnétiques sont adaptés pour être élevés et le premier et le second ensembles d'éléments de support de rouleau sont adaptés pour être abaissés,
où les premiers ensembles d'éléments de support magnétiques et de rouleau (312, 314), quand ils maintiennent un substrat (50) ou un support de substrat (52), peuvent être passés par les seconds ensembles d'éléments de support magnétiques et de rouleau (322, 324) durant un mouvement relatif des premier et second assemblages de support de substrat (310, 320) dans la direction de commutation, et vice versa.

8. Chambre (200) pour un système de traitement de substrat, comprenant :
au moins une première porte de transfert de substrat (210, 212) pour le transfert de substrat dans ou hors de la chambre le long d'un premier chemin de transport (T1),
au moins une seconde porte de transfert de substrat (220, 222) pour le transfert de substrat dans ou hors de la chambre le long d'un second chemin de transport (T2) ; et
un dispositif de transfert (100) selon l'une quelconque des revendications 1 à 7, le dispositif de transfert étant disposé dans la chambre.

9. Chambre selon la revendication 8, dans laquelle la chambre est une chambre de traitement de substrat pour le dépôt d'une couche sur un substrat,
où une position de traitement de substrat (P) est située dans la chambre de traitement de substrat, la position de traitement de substrat étant située à distance des premier et second chemins de transport ou étant située sur un des premier ou second chemins de transport, et
où les première et seconde pistes peuvent être individuellement alignées avec la position de traitement de substrat.

10. Procédé de déplacement d'un substrat (50) dans un système de traitement de substrat, le procédé comprenant :
le transfert du substrat (50) dans une chambre (200) le long d'un premier chemin de transport (T1) ;
le déplacement du substrat dans la chambre au moins dans une direction de commutation (S) perpendiculaire au premier chemin de transport (T1) ; et
le déplacement des éléments de support (322, 324) d'un assemblage de support de substrat vide (320) dans la chambre,
**caractérisé en ce que**
le substrat (50) et les éléments de support (322, 324) de l'assemblage de support de substrat vide sont déplacés relativement les uns aux autres dans la direction de commutation et passent les uns les autres.

11. Procédé selon la revendication 10, dans lequel le mouvement des éléments de support de l'assemblage de support de substrat vide comprend au moins un de ce qui suit :
un mouvement dans une direction d'évasion (E) perpendiculaire aux deux premier chemin de transport et direction de commutation, et
un mouvement dans la direction de commutation.

12. Procédé selon la revendication 10 ou 11, dans lequel le transfert du substrat comprend le transfert du substrat à supporter par une première piste définie par les premiers éléments de support (312, 314) d'un premier assemblage de support de substrat (310), où l'assemblage de support de substrat vide est un second assemblage de support de substrat et les éléments de supports de l'assemblage de support de substrat vide sont des seconds éléments de support définissant une seconde piste, où le déplacement du substrat comprend le déplacement de la première piste supportant le substrat ; et
où la première piste supportant le substrat et la seconde piste définie par les seconds éléments de support sont déplacés relativement l'une à l'autre dans la direction de commutation et passent l'une l'autre.

13. Procédé selon la revendication 12, comprenant
le pivotement ou l'inclinaison d'au moins une partie des seconds éléments de support (322, 324).

14. Procédé selon l'une quelconque des revendications 10 à 13, dans lequel la chambre a une position de traitement (P), et où le déplacement du substrat comprend le déplacement du substrat à la position de traitement, le procédé comprenant en outre :
le dépôt d'une couche sur le substrat dans la position de traitement.

15. Procédé selon l'une quelconque des revendications 10 à 14, comprenant en outre :
le transfert du substrat hors de la chambre le long d'un second chemin de transport (T2) ; et
le transfert simultané d'un second substrat (60) dans la chambre le long du premier chemin de transport (T1), où le second substrat est reçu par les éléments de support (322, 324) de l'assemblage de support de substrat vide (320).
